# EUROPEAN PATENT APPLICATION

(11) **EP 4 105 650 A1**
(43) Date of publication of application: **21.12.2022**
(21) Application number: 21305817.5
(22) Date of filing: 15.06.2021
(51) Int. Cl.: G01N 27/12, B01D 71/02

(54) **SENSOR DEVICE WITH COVER LAYER**

(71) Applicant: MEAS France, 31027 Toulouse Cedex 3 (FR)
(72) Inventor: DURUPT, Emilien, 31027 Toulouse (FR); ANDREU, Damien, 31027 Toulouse (FR)
(74) Representative: Grünecker Patent- und Rechtsanwälte PartG mbB

(57) **Abstract**

The present invention relates to a sensor device (10, 40) comprising a substrate (1, 31, 41), a sensing layer (2, 32, 42) formed over the substrate (1, 31, 41), sensing electrodes (3, 33, 43) and a cover layer (4, 44) covering at least partially the sensing layer (2, 32, 42) for protecting the sensing layer (2, 32, 42) against pollution. The cover layer (4, 44) comprises or consists of a porous material and/or the cover layer (4, 44) comprises a plurality of openings (O).

## Description

### Field of Invention

The present invention relates to a sensor device for sensing a measurand, for example, the absolute or relative humidity of an environment, and, in particular, the protection of a sensing layer of the sensor device used for the sensing operation.

### Background of the invention

Sensors are of growing importance and become more and more ubiquitous in every-day life. For example, microelectromechanical systems (MEMS) are an attractive option to answer the demand for increased performances of sensors along with decreased sizes and costs. For example, temperature sensors and humidity sensors or a combination thereof are known to be used in a large variety of applications including windshield sensing devices installed in vehicles for the purpose of automatically controlling the heating, ventilation, air conditioning and operation of the windshield wiper.

In the art, a humidity sensor device is known that comprises a dielectric substrate, two electrodes formed on the dielectric substrate and a sensitive layer for absorption and/or adsorption of water. A variation of capacitance, electrical conductivity, electrical resistivity or impedance caused by the absorption and/or adsorption of water can be measured and used for the determination of the (relative) humidity of an environment under the assumption that the water amount detected by the sensor is in thermal equilibrium with the gaseous fraction of water in the environment.

The sensing layer of the sensor device may be made of an organic polymer material. However, organic materials suffer from degradation during lifetime and are affected by relatively high temperatures that, for example, arise during the process of manufacturing of the sensor device or in-the-field operation in particular applications. Additionally, response times of conventional polymeric humidity sensor devices are relatively low (of the order of seconds). Therefore, recently, completely inorganic humidity sensor devices have been proposed which, for example, comprise inorganic dielectric layers serving as sensing layers.

In any case, the sensing layers or sensing cells comprising the sensing layers have to be protected against pollution, for example, present in air the humidity (or any other measurand) of which is to be measured. Pollution/contaminants in form of dust, polls, oil droplets or other material different from water (steam) particles may even cause short-circuiting of the sensing electrode of the sensor devices.

In the art, dust/fluid/mist sensor protections comprise polytetrafluorethylene (PTFE) membranes that are unitary glued on top of the packaged devices in a post packaging step. However, the attachment of the PTFE membranes represents a relatively laborious post-packing manufacturing process and, in addition, the protection quality and reliability of the PTFE membrane protections in harsh operation environments has proven not to be satisfying.

In view of the above, it is an object of the present invention to provide a sensor device that allows for a reliable and permanent sensing operation in harsh environments and that can be manufactured relatively easily.

### Description of the Invention

The present invention addresses the above-mentioned object by providing a sensor device according to claim 1. The sensor device comprises a substrate, a sensing layer formed over (for example, directly on) the substrate and sensing electrodes (at least one of which might be formed over the substrate, in particular, over the sensing layer). The sensing layer has physical and/or chemical properties (for example, an electrical conductivity or capacitance between the sensing electrodes) that vary depending on the quantity of a measurand (for example, temperature, pressure or humidity). Further, the sensor device comprises a cover layer (protection layer) covering at least partially the sensing layer (particularly, with or without contacting the sensing layer) for protecting the sensing layer against pollution. The cover layer may also provide protection against mechanical attacks. According to the invention, the cover layer comprises or consists of a porous material and/or the cover layer comprises a plurality of openings (vias). The openings extend completely through the cover layer in a thickness direction of the same. For example, the openings run parallel to the thickness direction or in some finite angle to the thickness direction. The openings may be formed in the cover layer after formation of the cover layer.

The cover layer may form a cavity surrounding at least partially the sensing layer and it may be partially formed on or attached to the substrate.

The cover layer protects the sensing layer (and the sensing electrodes depending on their actual arrangement) reliably against contamination by pollution present in a surrounding medium, for example, dust, pollens, oil droplets, etc. present in air. The cover layer represents a High Efficiency Particulate Filter (HEPF) against contaminants that can easily and relatively cheaply be manufactured and easily formed over the substrate.

The thus provided configuration can be easily produced by mass production semiconductor manufacturing processes. It can be manufactured at compact sizes and does not heavily suffer from severe deteriorations due to aging during its lifetime. The device can be manufactured and operated at relatively high temperatures up to about 300 °C, for example, or up to 1000 °C or even higher. Moreover, based on such a configuration a response time of less than a second can be achieved.

It has to be noted that the provided sensor device can be used as a stand-alone device for remote sensing in harsh environments characterized by high temperatures (of some 100 to some 1000 °C) and high pressures (for example, a few ten atm or more). According to a particular embodiment, the cover layer comprises or consists of a porous material having a porosity of more than 5 %, in particular, more than 60 % or 70 %. For applications with slowly varying measurands a porosity of less than 5 % might also be considered suitable, in principle. For example, the porous material comprises pores with average diameters of 5 nm to 200, 300 or 400 µm, in particular, 100 nm to 300 nm. The porous material may be a ceramic material, for example, a sintered ceramic material, that can be easily and cheaply produced and reliably provides longstanding filter properties. Ceramic material used for the cover layer may suitably be or comprise silicon carbide for high-temperature resistance. Other suitable materials for the porous cover layer include solid foam materials, for example, metal foam, exhibiting the above-mentioned porosities and/or diameter sizes of the pores. Such foam materials may be advantageous with respect to both durability and light weight.

According to an embodiment, the cover layer comprises openings allowing fluid contact between the sensing layer and the environment. The cover layer comprising openings may be or comprise a porous material or a non-porous material (for example, comprising or consisting of a dielectric or metal material or a combination thereof). The openings may be nano or micro-sized vias having average diameters of, for example, 5 nm to 200 µm, in particular, 100 nm to 300 nm. At least some of the openings may extend completely parallel to a thickness direction of the cover layer through the same. The openings may represent through-holes formed in the cover layer after the cover layer has been formed.

In all of the above-described embodiments, the cover layer may have a thickness of 100 nm to 10000 µm, in particular, 200 µm to 600 µm or 5000 to 10000 µm.

The mentioned porosities, diameters of the pores and/or openings and thicknesses of the cover layer may be advantageous with respect to an effective filtering of contaminants together with keeping short response times of the sensor device. In this context, it is to be understood that the pore and opening sizes can be adjusted to actual applications in order to prevent contamination, in particular, to particle sizes of contaminants.

In embodiments wherein the cover layer comprises openings, the sidewalls of the openings may be covered by some metal material. Thereby, electrostatic filter properties can be provided that may improve the protection against contaminants coming from the environment.

The substrate may be or comprise a semiconductor bulk substrate, a glass (and a borosilicate, in particular), a ceramic or an application-specific integrated circuit (ASIC) or an application-specific standard product (ASSP). The semiconductor bulk substrate can be made of or comprise (poly)silicon. A compact design employing an ASIC or ASSP can be achieved. It is noted that if an ASIC, ASSP, or a heat resistant acquisition circuit is used, some discrete electronics may be provided remotely, particularly, when high-temperature applications are envisaged.

The sensing layer may be an inorganic dielectric layer, for example, exhibiting a well-defined adsorption/absorption rate for water, and at least one of the sensing electrodes may be formed on or over the inorganic layer. In fact, no organic material may be comprised in the sensor device at all. Thereby, the ageing characteristics can be improved as compared to sensor devices comprising organic sensing layers or other organic components. The inorganic dielectric layer can be made of or comprise a nitride material, in particular, Si₃N₄ or silicon carbide.

For example, in the case of a resistive sensor a pair of interdigitated electrodes representing the sensing electrodes may be formed over an inorganic dielectric layer. The electrodes of the pair of interdigitated electrodes may be arranged in the same horizontal plane parallel to the inorganic dielectric layer. They may be made from the same layer and may terminate in electrode terminals that may also be formed from the same layer. In principle, the sensing electrodes, for example, the interdigitated electrodes, can be made of or comprise a noble metal, in particular, gold, platinum. Alternative materials that are suitable for manufacturing the electrodes include aluminum and copper. An adhesion layer (made of chromium, for example) that insures a stable adhesion of the electrodes on the substrate can also be deployed.

The sensor device may comprises a sensing circuit configured for measuring at least one of an electrical resistance of the sensing layer, an electrical (surface) conductivity of the sensing layer, an impedance of the sensing layer, a capacity of the capacitor formed by the sensing electrodes and the sensing layer and a current flowing through the sensing layer. Particularly, the sensor device may be configured for sensing temperature, pressure, relative or absolute humidity or a combination of these measurands.

For example, in the case of a humidity sensor device, by an appropriate circuitry the amount of water absorbed/adsorbed by the sensing layer, for example, the inorganic dielectric layer mentioned above, can be determined and based on the determined amount of water the humidity or relative humidity of an environment can be determined given that the temperature of the environment is known. The temperature of the environment can be determined by means of a temperature sensor that may be comprised in the humidity sensor device (combined humidity and temperature sensor) or an additional temperature sensor that may also comprise a cover layer similar to the above-described cover layer. As already mention the inventive sensor device itself may be a temperature sensor device or a pressure sensor device. Moreover, a number of sensing elements of a combined sensor device, for example sensing elements for sensing pressure, humidity, temperature, etc., may be covered by the same protection layer.

The above-mentioned object is also addressed by providing a method of manufacturing a sensor device, comprising the steps of:
providing a (semiconductor) wafer;
forming a plurality of sensing layers (for example, by forming a continuous sensing layer and patterning the same) over the provided wafer;
forming sensing electrodes (for example, by forming a continuous electrode layer and patterning the same) over and/or in the wafer;
forming a continuous cover layer over each of the plurality of sensing layers, the continuous cover layer comprising or consisting of a porous material and/or the continuous cover layer comprising a plurality of openings; and

dicing the wafer to obtain a plurality of intermediate sensor devices each of which includes one of the plurality of sensing layers and an individual cover layer formed from the continuous cover layer by the dicing.

Alternatively, the step of forming the continuous cover layer is omitted and individual cover layers are formed after the wafer dicing on the individual dies. However, the method comprising the formation of the continuous cover layer in the context of wafer scale assembly may be advantageous in mass production. Thus, a wafer scale (wafer bonding) assembly of the continuous cover layer onto the finalized wafer, for example, ASIC wafer, may be preferred. The continuous cover layer can, advantageously, be attached to the wafer in the clean room before dicing and packaging.

The continuous cover layer and individualized cover layers may be made of the same materials and can exhibit the same properties as described above with reference to embodiments of the provided sensor device. In particular, it is provided a sensor device, in particular, a (relative) humidity sensor device, temperature sensor device or pressure sensor device, obtainable by the above-described method. All embodiments of the inventive sensor device described above may be obtained by the provided method.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an exemplary embodiment of a sensor device comprising a porous cover layer according to the present invention.
Figure 2 illustrates a flow chart of a process of manufacturing of a sensor device according to an embodiment.
Figure 3 illustrates a pre-dicing wafer configuration from which the sensor device shown in Figure 1 can be obtained.
Figure 4 illustrates an exemplary embodiment of a sensor device comprising a cover layer with a plurality of openings according to the present invention.

The present invention provides a sensor device that is, for example, suitable for sensing a (relative) humidity, temperature or pressure of an object or environment. According to the invention, the sensor device comprises a cover layer that comprises or consists of a porous material and/or comprises a plurality of openings. The cover layer provides protection against pollution. The provided sensor device can be manufactured relatively easily by mass production semiconductor manufacturing techniques and, particularly, resists relatively high temperatures and chemically harsh environments.

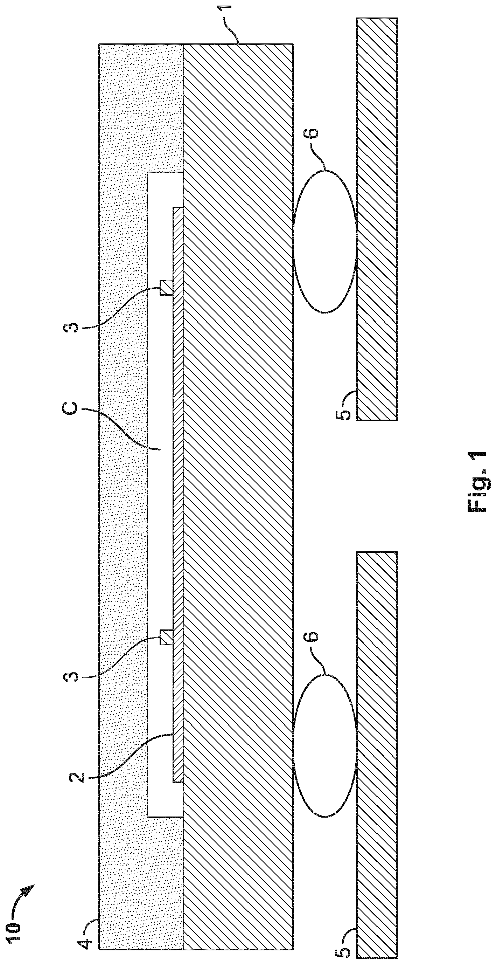

Figure 1 exemplarily shows an embodiment of a sensor device 10 according to the invention. The sensor device 10 may be configured for sensing a relative humidity and/or temperature or pressure of air or another medium/object. According to the embodiment shown in Figure 1 the sensor device 10 comprises a substrate 1. The substrate 1 may be a semiconductor bulk substrate, for example, a (poly)silicon substrate, or an ASIC or ASSP.

Furthermore, the sensor device 10 comprises a sensing layer 2 and a sensor cell comprising a sensing layer 2 and, for example, being wire connected to a printed circuit board, wherein the sensing layer 2 is formed on or over the substrate 1. The sensing layer 2 may be an adsorbing and/or absorbing layer (for example, for adsorbing and/or absorbing water) in the case of a humidity sensor device. For example, the sensing layer 2 is an inorganic dielectric layer. The inorganic dielectric layer may be a nitride layer, for example, an Si₃N₄ layer. In any case, the sensing layer 2 exhibits detectable properties varying in accordance with variations of a measurand.

Sensing electrodes 3 are formed on or over the sensing layer 2. All sensing electrodes 3 can be made of the same material. For example, the sensing electrodes 3 can be made of or comprise a noble metal, in particular, gold, to provide for chemical resistance and durability. Voltages can be applied via electrode terminals (not shown in Figure 1) that can be made of the same material as the sensing electrodes 3. For example, a pair of interdigitated electrodes is formed in the same horizontal plane over the sensing layer 2. It is explicitly noted that the invention is not limited to a particular electrode configuration. Formation of the pair of interdigitated electrodes over the inorganic dielectric layer 2 can be facilitated by means of an adhesion layer formed on the sensing layer 2 (not shown in Figure 1) wherein the adhesion layer is, for example, made of or comprising Cr.

For example, a current flowing through the sensor layer 2 between the (for example, interdigitated) electrodes 3 or an electrical resistance or electrical (surface) conductivity exhibited by the sensing layer 2 between the (for example, interdigitated) electrodes 3 may be determined as a function of the relative humidity giving rise to the adsorption of water in the sensing layer 2 or as a function of another measurand.

The sensing layer 2 (as well as the sensing electrodes 3) is protected against pollution from the environment (for example, dust, pollens, oil droplets, etc. present in air) by means of a cover layer 4 formed on or attached to the substrate 1 that forms a cavity surrounding the sensing layer 3 (without contacting the sensing layer 3).

According to an embodiment, the cover layer 4 comprises or consists of a porous material, for example, a porous ceramic material, particularly, a sintered ceramic material. For example, a sintering process for forming the sintered ceramic material may be performed at a temperature of above 1,500 °C or, depending, on the usage of sintering additives at a temperature of lower than 1200 °C. According to particular embodiments, the ceramic material used for the cover layer 4 is or comprises silicon carbide exhibiting a decomposition temperature of above 2,500 °C. According to an alternative embodiment, the porous material is a solid foam material, for example, a metal foam. Moreover, the porous material may have a porosity of more than 5 % or 50 %, in particular, more than 60 % or 70 %. For example, the porous material comprises pores with average diameters of 5 nm to 200 µm, in particular, 100 nm to 300 nm. The cover layer 4 may have a thickness of 100 nm to 10000 µm, in particular, 200 µm to 600 µm or 5000 to 10000 µm. Thus, the cover layer 4 allows for effective filtering of contaminants together with keeping short (for example, sub-second) response times provided by the sensor device 10.

The sensor device 10 can be contacted to an electronic equipment/circuitry 5 by solder bumps 6 formed on a lower surface of the substrate 1.

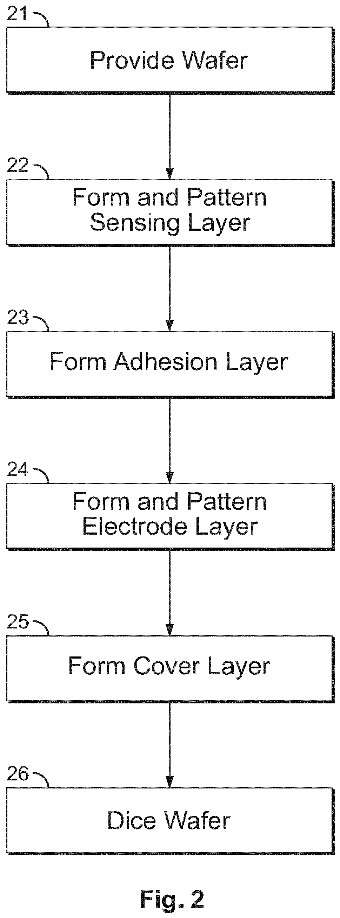

A process of manufacturing a sensor device according to an embodiment of the invention will now be described with reference to Figure 2. For example, by the process flow illustrated in Figure 2 the sensor device 10 shown in Figure 1 can be produced.

As shown in Figure 2 a wafer, for example, an ASIC wafer, is provided 21 and a sensing layer, for example, in form of an inorganic dielectric layer, for example, an Si₃N₄, layer is formed, for example, grown, and patterned 22 over the wafer. The sensing layer may be part of a sensor cell formed over the wafer. After the formation and patterning 22 of the sensing layer an adhesion layer, for example, a Cr layer, is formed 23 over the patterned sensing layer and an electrode layer, for example, an Au layer, is formed and patterned 24 over the adhesion layer. The formation of the electrode layer may comprise vapor deposition and the patterning may comprise the formation of a photoresist (positive or negative) and subsequent photolithography processing and reactive ion etching or wet etching.

In step 25 of the flow chart shown in Figure 2 a cover layer is formed on or over the wafer and at least partially over of the sensing layer. The cover layer comprises or consists of a porous material, for example, a porous ceramic material as, for example, silicon carbide, and, in particular, a sintered ceramic material. For example, a sintering process for forming the sintered ceramic material may be performed at a temperature of above 1,500 °C or, depending, on the usage of sintering additives at a temperature of lower than 1200 °C. Alternatively, the porous cover layer may comprise or consist of a foam material, for example, metal foam.

Moreover, the porous material used for the cover layer may have a porosity of more than 5 % or 50 %, in particular, more than 60 % or 70 %. For example, the porous material comprises pores with average diameters of 5 nm to 200 µm, in particular, 100 nm to 300 nm. The cover layer may have a thickness of 100 nm to 10000 µm, in particular, 200 µm to 600 µm or 5000 to 10000 µm. The cover layer is formed in order to provide protection for the sensing layer and electrodes against pollution and may also provide mechanical protection.

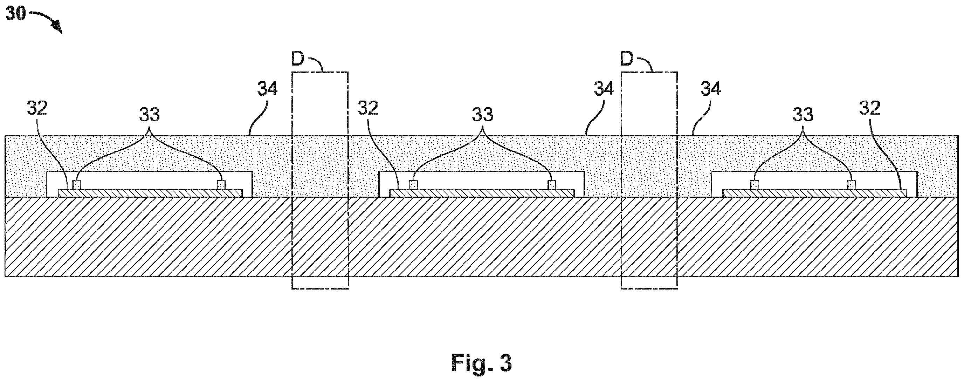

A typical pre-dicing wafer configuration 30 that results after the completion of step 25 of Figure 2 is shown in Figure 3. On the wafer 31 a plurality of sensing layers 32 are formed and over the plurality of sensing layers a plurality of sensing electrodes 33 are formed. Each of the plurality of sensing layers 32 is protected by a porous (for example, ceramic or solid foam) cover layer 34 continuously formed over the wafer 31. Individual dies for individual (intermediate) sensor devices can be formed by dicing at the dicing regions D shown in Figure 3.

Thus, the pre-dicing wafer configuration resulting after step 25 of Figure 2, for example, the configuration illustrated in Figure 3, is diced/cut in order to produce individual dies (see step 26 of Figure 2) comprising individual cover layers. It is noted that according to an alternative embodiment, no continuous cover layer is formed in the pre-dicing wafer configuration and, rather, individual cover layers are attached to the dies after dicing of the wafer. Electrode terminals can be used for wire bonding to a printed circuit board by means or suitable wires. The printed circuit board may comprise a measuring and control circuitry for processing sensed data and controlling the sensor device resulting from the manufacturing process illustrated in Figure 2. The printed circuit board may comprise any on-chip circuits that carry out automatic calibration and signal processing.

In the above-described manufacturing process flow no organic materials need to be involved that are damageable by relative high temperatures involved in the overall mass product manufacturing process. This aspect in combination with the provided cover layer allows for in-situ operation of the obtained sensor device in relatively hot (up to some 1000 °C, for example) and chemically aggressive environments.

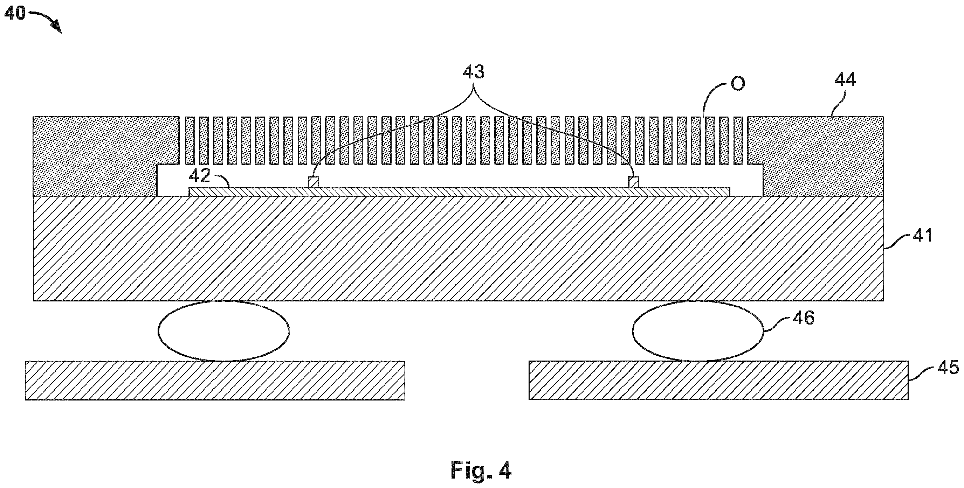

Figure 4 shows an alternative embodiment of an inventive sensor device 40. It may be manufactured by the same or a similar method as described above with reference to Figures 2 and 3. The sensor device 40 comprises a substrate 41, a sensing layer 42 and sensing electrodes 43. The substrate 41, the sensing layer 42 and the sensing electrodes 43 may be the same or similar to the substrate 1, the sensing layer 2 and the sensing electrodes 3 of the embodiment of an inventive sensor device 10 shown in Figure 1.

Different from the embodiment shown in Figure 1 the sensor device 40 shown in Figure 4 comprises a cover layer 44 exhibiting vertical openings O. The openings can be nano-sized vias with average diameters of 5 nm to 200 µm, in particular, 100 nm to 300 nm. The openings O allow for a fluid communication from the environment of the sensor device 40 to its interior but, due to their sizes, prevent contaminants from entering the sensor device 40 and disadvantageously contacting the sensing layer 42. The openings O take over the role of the pores of the porous material of the cover layer 4 described with reference to Figure 1.

The cover layer 44 may be made of or comprises a non-porous dielectric and/or metal material. In principle, the cover layer 44 may be made of or comprises a porous material as described above and the openings 44 are additionally provided for enhancing fluid communication. In any case, the openings O may be formed after formation of the cover layer 44, for example, by etching. As shown in Figure 4, the openings/vias O may run parallel to a thickness direction of the cover layer 44. Alternatively, at least some of them may run at some finite angle to the thickness direction of the cover layer 44.

According to an embodiment, the surfaces of the openings O are coated by some metal material. Thereby, electrostatic filtering properties can be provided that might prove advantageous with respect to the overall filtering/protection efficiency of the cover layer 44.

All previously discussed embodiments are not intended as limitations but serve as examples illustrating features and advantages of the invention. It is to be understood that some or all of the above described features can also be combined in different ways.

### Reference Numbers

- 10, 40:: humidity sensor device
- 1, 31, 41:: substrate
- 2, 32, 42:: sensing layer
- 3, 33, 43:: sensing electrodes
- 4, 44:: cover layer
- 5, 45:: electronic equipment/circuitry
- 6, 46:: solder bumps
- 30:: pre-dicing wafer configuration
- 34:: continuous cover layer
- O:: openings

## Claims

1. Sensor device (10, 40), comprising
a substrate (1, 31, 41);
a sensing layer (2, 32, 42) formed over the substrate (1, 31, 41);
sensing electrodes (3, 33, 43); and
a cover layer (4, 44) covering at least partially the sensing layer (2, 32, 42) for protecting the sensing layer (2, 32, 42) against pollution; and wherein
the cover layer (4, 44) comprises or consists of a porous material and/or the cover layer (4, 44) comprises a plurality of openings (O).

2. The sensor device (10, 40) according to claim 1, wherein the cover layer (4, 44) comprises or consists of a porous material having a porosity of more than 5% or more than 50 %, in particular, more than 60 % or 70 %.

3. The sensor device (10, 40) according to claim 2, wherein the porous material comprises pores with average diameters of 5 nm to 200 µm, in particular, 100 nm to 300 nm.

4. The sensor device (10, 40) according to one of the preceding claims, wherein the cover layer (4, 44) comprises or consists of a porous ceramic material, in particular, silicon carbide.

5. The sensor device (10, 40) according to one of the claims 1 to 3, wherein the cover layer (4, 44) comprises or consists of a porous solid foam material, in particular, metal foam.

6. The sensor device (10, 40) according to claim 1, wherein the cover layer (4, 44) comprises or consists of a non-porous material and comprises a plurality of openings (O) having average diameters of 5 nm to 200 µm, in particular, 100 nm to 300 nm.

7. The sensor device (10, 40) according to claim 1 or 6, wherein the cover layer (4, 44) comprises a plurality of openings (O) with sidewalls covered by a metal material.

8. The sensor device (10, 40) according to one of the preceding claims, wherein the cover layer (4, 44) has a thickness of 100 nm to 1000 µm or 10000 µm, in particular, 200 µm to 600 µm.

9. The sensor device (10, 40) according to one of the preceding claims, wherein the cover layer (4, 44) forms a cavity at least partially around the sensing layer (2, 32, 42).

10. The sensor device (10, 40) according to one of the preceding claims, wherein the cover layer (4, 44) is attached to or formed partially on the substrate (1, 31, 41).

11. The sensor device (10, 40) according to one of the preceding claims, wherein the sensing layer (2, 32, 42) is an inorganic dielectric layer, in particular, made of or comprising a nitride material, in particular, Si₃N₄.

12. The sensor device (10, 40) according to one of the preceding claims, wherein the substrate (1, 31, 41) is a semiconductor bulk substrate or a semiconductor microcircuit, in particular, an ASIC or ASSP.

13. The sensor device (10, 40) according to one of the preceding claims, wherein the sensor device (10, 40) is configured for sensing temperature, pressure, relative or absolute humidity or a combination thereof.

14. The sensor device (10, 40) according to one of the preceding claims, further comprising a sensing circuit configured for measuring at least one of an electrical resistance of the sensing layer (2, 32, 42), an electrical conductivity of the sensing layer (2, 32, 42), an impedance of the sensing layer (2, 32, 42), a capacity of the capacitor formed by the sensing electrodes (3, 33, 43) and the sensing layer (2, 32, 42) and a current flowing through the sensing layer (2, 32, 42).

15. Method of manufacturing a plurality of sensor devices (10, 40), comprising the steps of:
providing a wafer;
forming a plurality of sensing layers (2, 32, 42) over the provided wafer;
forming sensing electrodes (3, 33, 43) over and/or in the wafer;
forming a continuous cover layer (34) over each of the plurality of sensing layers (2, 32, 42), the continuous cover layer (34) comprising or consisting of a porous material and/or the continuous cover layer (34) comprising a plurality of openings; and
dicing the wafer to obtain a plurality of intermediate sensor devices (10, 40) each of which includes one of the plurality of sensing layers (2, 32, 42) and an individual cover layer (4, 44) formed from the continuous cover layer (34) by the dicing.
